Europäisches Patentamt

European Patent Office

Office européen des brevets

(19)

(11) Veröffentlichungsnummer: **0 092 671**

**A2**

(12) # EUROPÄISCHE PATENTANMELDUNG

(21) Anmeldenummer: 83102607.5

(22) Anmeldetag: 16.03.83

(51) Int. Cl.³: **H 01 L 29/72**
**H 01 L 29/36, H 01 L 21/74**

(30) Priorität: 27.04.82 DE 3215652

(43) Veröffentlichungstag der Anmeldung:
02.11.83 Patentblatt 83/44

(84) Benannte Vertragsstaaten:
DE FR GB IT

(71) Anmelder: SIEMENS AKTIENGESELLSCHAFT
Berlin und München Wittelsbacherplatz 2
D-8000 München 2(DE)

(72) Erfinder: Werner, Wolfgang, Dr. Ing.
Lorenzonistrasse 66
D-8000 München 90(DE)

(54) Integrierbarer bipolarer Transistor.

(57) Der Ausgangspunkt der Erfindung ist durch eine für IC's geeignete bipolare Transistorstruktur gegeben, wie sie in der DE-OS 30 29 553 beschrieben ist. Für diese Struktur ist wesentlich, daß die Basiszone eine größere laterale Querschnittsfläche als die unterhalb von ihr mit Abstand angeordnete und der Verminderung des Kollektor-Bahnwiderstands dienende vergrabene Zone (buried-layer) hat. Außerdem soll sie längs ihres Rands überall seitlich über die vergrabene Zone hinausragen. Aufgrund dieser Maßnahmen entsteht ein parasitärer Junction Feldeffekttransistor, der dafür sorgt, daß der Transistor eine erhebliche Vergrößerung seiner Durchbruchspannung erhält. Aufgabe der Erfindung ist es nun, noch eine weitere Erhöhung der Durchbruchspannung zu erreichen. Hierzu werden nun gemäß der Erfindung die Dotierung der den Transistor mit Ausnahme der vergrabenen Zone aufnehmenden epitaxialen Halbleiterschicht und damit die Grunddotierung als auch die Substratdotierung derart aufeinander abgestimmt, daß sich aufgrund einer bereits merklich unterhalb der CE-Durchbruchspannung liegenden Betriebsspannung eine Wechselwirkung zwischen den Raumladungszonen ergibt, die einerseits vom Basis-Kollektorübergang und andererseits vom Substrat-Kollektorübergang ausgehen und während des Betriebs des Transistors entstehen.

FIG 2

Siemens Aktiengesellschaft          Unser Zeichen
Berlin und München                  VPA  82 P 1 3 3 2 E

## Integrierbarer bipolarer Transistor

Die Erfindung bezieht sich auf einen integrierbaren bipolaren Transistor, bei dem an der Oberfläche eines monokristallinen Halbleitersubstrats vom einen Leitungstyp eine den entgegengesetzten Leitungstyp aufweisende monokristalline Halbleiterschicht epitaktisch abgeschieden und in ihr der Transistor erzeugt ist, bei der dabei am Ort des Transistors im Substrat eine vergrabene Zone hoher Dotierungskonzentration vom Leitungstyp der epitaktischen Halbleiterschicht vorgesehen und die Basiszone des Transistors oberhalb der vergrabenen Zone und mit Abstand von dieser so erzeugt ist, daß die Basiszone längs ihres Randes überall gegenüber dem Rand der vergrabenen Zone seitlich hinausragt, bei dem außerdem die Kollektorzone von dem die ursprüngliche Dotierung der epitaktischen Schicht aufweisenden Bereich gebildet ist, in welchem die Basiszone eingebettet ist, und bei dem schließlich an dem die Kollektorzone begrenzenden Teil der Oberfläche der epitaktischen Schicht eine im Vergleich zur Kollektorzone stärker dotierte Kontaktierungszone mit Abstand vom Rand der Basiszone vorgesehen ist.

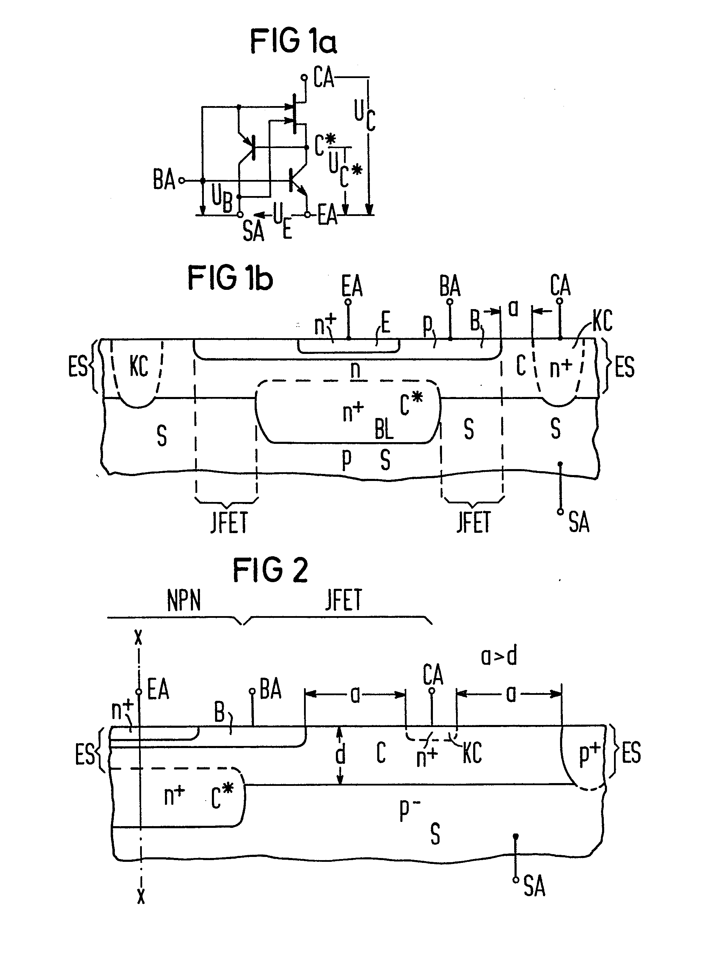

Eine solche Transistorstruktur ist z.B. in der DE-OS 30 29 553 (=VPA 80 P 1120) beschrieben. Sie führt zu einer hohen Kollektor-Emitter-Durchbruchsspannung. Dabei ist wie üblich die hochdotierte Emitterzone in die schwächer dotierte Basiszone eingebettet, wie aus Figur 1 ersichtlich ist. Das Wesentliche an dieser Struktur ist, daß die vergrabene Zone, also der sog. buried layer, seitlich von der Basiszone überragt wird, was zu einer beträchtlichen Erhöhung der Spannungsfestigkeit des Transistors führt, wie im folgenden noch dargelegt wird.

Nun ist für eine integrierte Schaltung gegebenenfalls die Kombination von schneller Logik hoher Packungsdichte mit einem oder mehreren Transistoren hoher Spannungsfestigkeit (z.B. mit einem Transistor mit $U_{CEO} \approx 100$ V) erwünscht. Beispielsweise kommt dies für eine Schaltung der Unterhaltungselektronik, der Vermittlungstechnik und der Autoelektronik in Betracht. Jedoch läßt sich eine solche monolithische Kombination bei Anwendung der üblichen Bipolartechnik nicht so ohne weiteres realisieren.

Denn die Realisierung eines Transistors mit einer hohen Kollektor-Emitter-Durchbruchsspannung verlangt eine entsprechend dicke Epitaxieschicht und eine sehr niedrige Dotierungskonzentration im Kollektorbereich, die bei dem üblichen Herstellungsverfahren mit der ursprünglichen Dotierung der epitaktischen Schicht identisch ist. Will man z.B. die Durchbruchsspannung $U_{CEO}$ auf etwa 100 V steigern, so ist eine Stärke von 30 /um für die epitaktische Schicht und eine Dotierungskonzentration von ca. $10^{15}/cm^3$ im Falle eines npn-Transistors erforderlich.

Andererseits ist für eine schnelle Logik mit hoher Packungsdichte, z.B. einer ECL- oder einer $I^2L$-Schaltung, eine im Bereich von 1,5 und 4 /um dicke epitaktische Schicht mit einer Grunddotierung im Bereich von 0,7 bis $3 \cdot 10^{16}$ $cm^{-3}$ angebracht, welche bei einem in ihr erzeugten npn-Transistor mit buried-layer-Zone nur zu einer Emitter-Kollektor-Durchbruchspannung $V_{CEO}$ von 5 bis 15 V führt. Die genannten Zahlen gelten für die Verwendung von Silicium als Halbleitermaterial und einen Transistor vom npn-Typ. Für Transistoren vom pnp-Typ bzw. für die Verwendung eines anderen Halbleitermaterials, z.B. von GaAs, gelten ähnliche Verhältnisse.

Geht man nun von der üblichen Struktur eines vertikalen Bipolartransistors aus, wie sie z.B. in "Industrie-Elektrik + Elektronik" 12. Jahrg. 1967, Nr. B 7/8, auf S. 126 dargestellt ist, so ist bei dieser Standartstruktur festzustellen, daß sich die vergrabene Zone seitlich über den seitlich über den Rand der Basiszone längs dessen Gesamtverlauf seitlich hinaus erstreckt. Wenn man nun aber die vergrabene Zone lateral so verkleinert, daß am Rande der Basis ein von der vergrabenen Zone nicht unterlegter Streifen mit geeigneter Breite entsteht, so bildet - eine passende Dotierung der epitaktischen Schicht sowie eine ausreichende Dicke derselben vorausgesetzt - dieser seitlich über die vergrabene Zone hinausragende Bereich der Basiszone zusammen mit dem darunterliegenden Epigebiet und dem angrenzenden und die ursprüngliche Dotierung aufweisenden Bereich des Substrats einen Junction-Feldeffekttransistor, wobei (vgl. Fig.1a) die Basis B und das Substrat S die Gateelektroden des JFET's bilden, während die Source- und Drainelektroden dem inneren Kollektor $C^*$ bzw. dem äußeren Kollektor C ersprechen.

Figur 1 zeigt die Struktur im Querschnitt (vgl. Figur 1b), wobei der JFET den vertikalen npn-Transistor ringförmig umgibt. Unter der Bedingung $U_P < U_{C^*EO}$ übernimmt nun der JFET den größten Teil der am äußeren Kollektoranschluß CA anliegenden Spannung $U_C$ ($U_P$ = pinch off-Span-nung des JFET's). Die in Fig. 1b dargestellte und dem eingangs definierten Stand der Technik entsprechende Transistorstruktur hat somit das aus Figur 1a ersichtliche Verhalten und führt deshalb bei ihrer Anwendung zu Transistoren, die mit einem Vielfachen der Kollektor-Emitter-Durchbruchspannung $U_{C^*EO}$ des Standart-npn-Transistors betrieben werden können. Typische Durchbruchspannungen liegen bei $U_{CEO}$ = 50 V (für:Epitaxiedicke ca. 2,5 $\mu$m, Epitaxiedotierung ca. $10^{16}$ cm$^{-3}$).

Die vorliegende Erfindung hat nun die Aufgabe, die ingangs definierte Transistorsstruktur weiterzuentwickeln, so daß der diese Struktur aufweisende Transistor mit noch weitaus höheren Spannungen betrieben werden kann, da die Anwendung der vorliegenden Erfindung Belastungen bis zu einer Grenze $U_{CEO}$ zuläßt, die über 150 V liegt. Die Steigerung der Spannungsfestigkeit wird durch eine Optimierung sowohl der Geometrie der Transistorstruktur als auch der Grunddotierung der epitaktischen Schicht und damit der Kollektorzone erhalten.

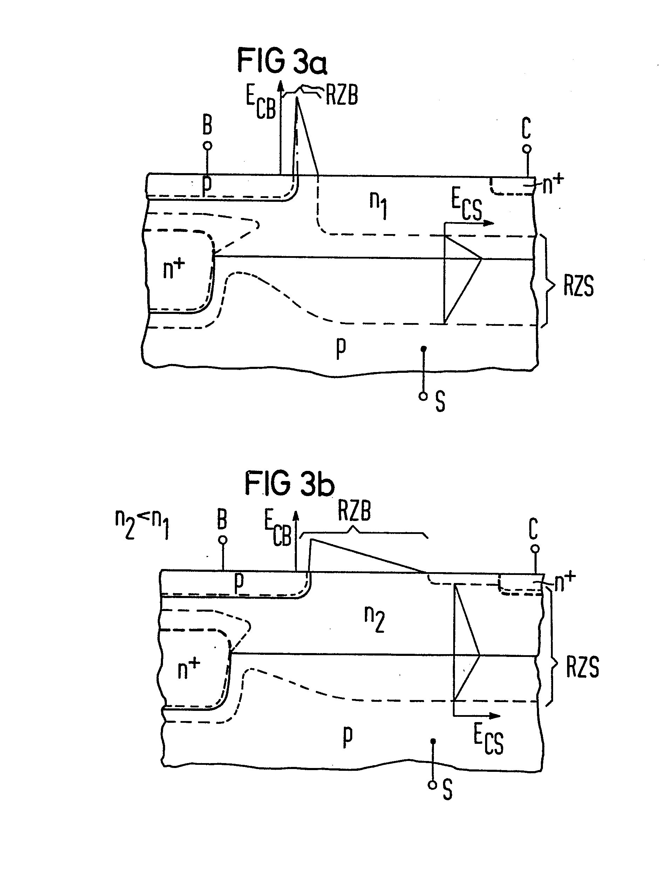

Erfindungsgemäß ist hierzu vorgesehen, daß die Stärke und die Grunddotierung der epitaktischen Schicht sowie die Substratdotierung außerhalb der vergrabenen Zone derart aufeinander abgestimmt sind, daß schon bei im Vergleich zur Durchbruchspannung merklich kleineren Betriebsspannungen sich die an der Grenze zwischen dem Kollektor und dem Substrat im Kollektorbereich ausbildende Raumladungszone mit der sich am Kollektor-Basis-Übergang im Kollektorbereich ausbildenden Raumladungszone in Wechselwirkung tritt , derart, daß die Kollektor-Basisspannung längs einer merklich größeren Strecke abfällt (vergl. Fig. 3b), als dies im Falle einer erheblich' höheren Epidotierung der Fall wäre (vergl. Fig. 3a).

Bei den gemäß der Erfindung anzuwendenden Dotierungs- und Geometrieverhältnissen ist somit erreicht, daß die C-B-Spannung über einer sehr viel größeren Strecke abfällt, als dies der Fall wäre, wenn die Epitaxiedicke sehr viel größer als die Ausdehnung der Raumladungszone wäre, was zur Folge hat, daß die Durchbruchsfeldstärke erst bei erheblich größeren CB-Spannungen erreicht wird.

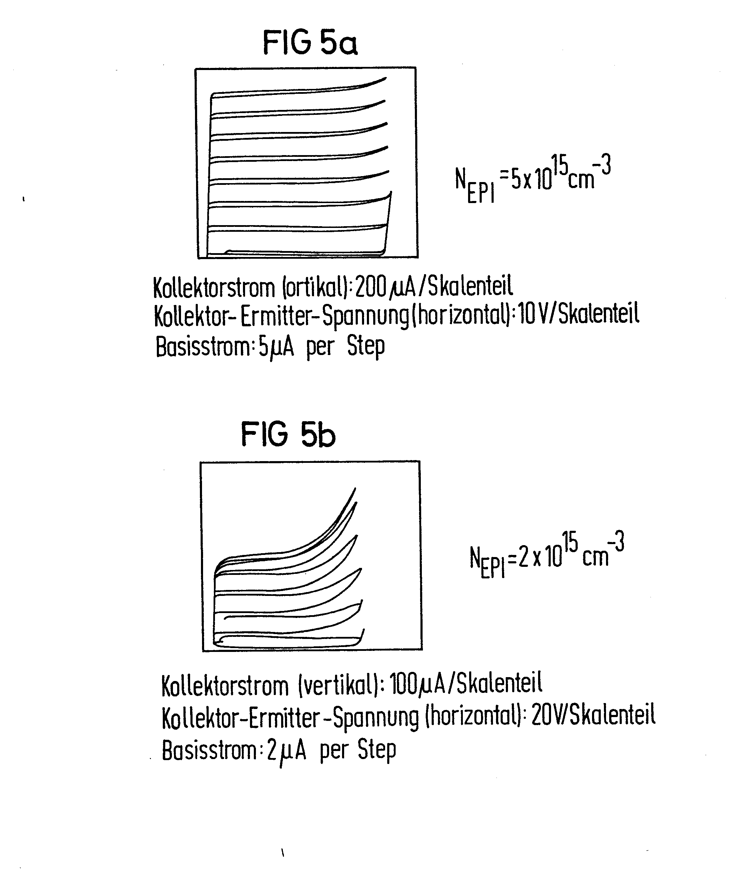

Die Erfindung wird nun anhand der Figuren 1 bis 6 näher beschrieben, dabei ist in Figur 1 (= Fig. 1a und 1b), die aus der DE-OS 30 29 553 bekannte Struktur als auch das zugehörige Ersatzschaltbild dargestellt. Zunächst wird nochmals auf die Figur 1 Bezug genommen.

Das aus p-dotiertem monokristallinen Silicium bestehende Substrat S ist an seiner Oberseite mit einer den eigentlichen Transistor aufnehmenden epitaktischen mono-

0092671

kristallinen epitaktischen Siliciumschicht ES mit einer n-Grunddotierung vorgesehen. Die in üblicher Weise erzeugte vergrabene Zone BL mit $n^+$-Dotierung liegt zum größten Teil im Substratbereich und reicht (aus bekannten Gründen) etwas in die epitaktische Schicht hinein. Sie hat die Aufgabe , den Kollektor-Bahnwiderstand zu reduzieren. Die an der Oberfläche der epitaktischen Schicht ES oberhalb der vergrabenen Zone BL erzeugte p-dotierte Basiszone B ist durch eine die n-Grunddotierung der epitaktischen Schicht ES aufweisende und einen Teil der inneren Kollektorzone $C^*$ bildende Zwischenzone von der vergrabenen Zone BL getrennt. Die Basiszone B erstreckt sich seitlich überall über die Vergrabene Zone BL hinaus, so daß es zu der bereits angegebenen JFET-Funktion kommt. Schließlich ist in der epitaktischen Schicht eine bis zum Substrat S reichende, insbesondere den Transistor ringförmig umschließende $n^+$-dotierte Kontaktierungszone KC für den Kollektor C des Transistors vorgesehen. Der ebenfalls $n^+$-dotierte Emitter E ist in die Basiszone B eingebettet. EA, BA, CA und SA sind die Anschlüsse für den Emitter, die Basis, den Kollektor und das Substrat S, die in üblicher Weise ausgebildet sind.

Die soeben beschriebene und in Fig. 1b dargestellte Transistorstruktur führt zu einem Ersatzschaltbild, wie es aus Figur 1a ersichtlich ist. Nähere diesbezügliche Einzelheiten findet man in der DE-OS 30 29 553, so daß von einer entsprechenden Darstellung an dieser Stelle abgesehen werden kann.

Eine im Sinne der Erfindung optimierte Transistorstruktur ist in Figur 2 im Schnitt dargestellt. Eine für die Erfindung wesentliche Maßnahme ist eine Vergrößerung des Abstands a zwischen dem Rand der Basiszone B und der Grenze des Kollektor-Kontaktierungsbereiches KC. Weiterhin ist die Tiefe der Kontaktierungszone KC in der epitaktischen Schicht ES wesentlich kleiner als bei der in Figur 1 dargestellten bekannten Struktur, und entspricht der Tiefe der Emitterzone E. Zweckmäßig wird man deshalb die Zonen KC und E gleichzeitig in einem gemeinsamen Dotierungsprozeß herstellen.

Unter der Voraussetzung einer geeigneten Grunddotierung der epitaktischen Schicht ES und damit der Kollektorzone C sowie des Substrats S findet aufgrund der an den Transistoranschlüssen sowie am Substratanschluß SA angelegten Betriebspotentiale eine Verarmung der Epitaxieschicht ES in dem den Junction-Feldeffekttransistor JFET bildenden Bereich an beweglichen Majoritätsträgern statt, bevor das elektrische Feld im Basis-Kollektor-pn-Übergang die Durchbruchsfeldstärke erreichen kann.

Dies wird nun anhand von Fig. 3a und 3b verständlich gemacht, wo der Verlauf des elektrischen Feldes am CB- und im CS-pn-Übergang bei sonst übereinstimmenden Verhältnissen für zwei verschiedene Größen der Grunddotierung in der epitaktischen Schicht ES und damit im Kollektor C des Transistors dargestellt ist. Für den Fall einer hinreichend stärkeren Dotierung der epitaktischen Schicht ES wird, wie aus Fig. 3a ersichtlich, der Durchbruch des Transistors von dem vertikalen Teil des CB-pn-Übergangs bestimmt. Mit abnehmender Konzentration der Grunddotierung in der epitaktischen Schicht ES wird die Wechselwirkung zwischen der aufgrund des CB-pn-Übergangs in der epitaktischen Schicht, also im Kollektorbereich C, auftretenden Raumladungszone $R_{ZB}$ und der aufgrund des CS-pn-Übergangs in der epitaktischen Schicht ES auftretenden Raumladungszone $R_{ZS}$ immer stärker. Diese gegenseitige Beeinflussung führt dazu, daß die Quellen des Feldes in der CB-Raumladungszone immer weiter vom metallurgischen CB-Übergang wegrücken, wie dies aus Figur 3b ersichtlich ist.

Dies bedeutet, daß die kritische Durchbruchfeldstärke erst bei höheren CB-Spannungen erreicht wird. Es wird also aufgrund der Erfindung eine gegenseitige Beeinflussung der aufgrund des CB-pn-Übergangs und der aufgrund des CS-pn-Übergangs sich im Kollektorbereich des Transistors ausbildenden Raumladungszonen im Sinne einer Erhöhung der Durchbruchspannung erreicht, wobei im Idealfall die Durchbruchsspannung des planen CS-pn-Übergangs die Spannungsfestigkeit $U_{CEO}$ des Transistors begrenzt.

Figur 4 zeigt die experimentell bestimmte Abhängigkeit der CE-Durchbruchsspannung von der Epitaxiedotierung. Zum Vergleich ist die Abbruchspannung eines planen CS-pn-Übergangs und eines gekrümmten CB-pn-Übergangs dargestellt (Krümmungsradius entspricht dem des Basis-Kollektor-pn-Übergangs).

Figur 5 zeigt die typischen Kennlinien des erfindungsgemäßen Hochvolttransistors. Im gleichen Prozeß hergestellte Standarttransistoren erreichen lediglich eine $U_{CEO}$ Spannung von 10 V.

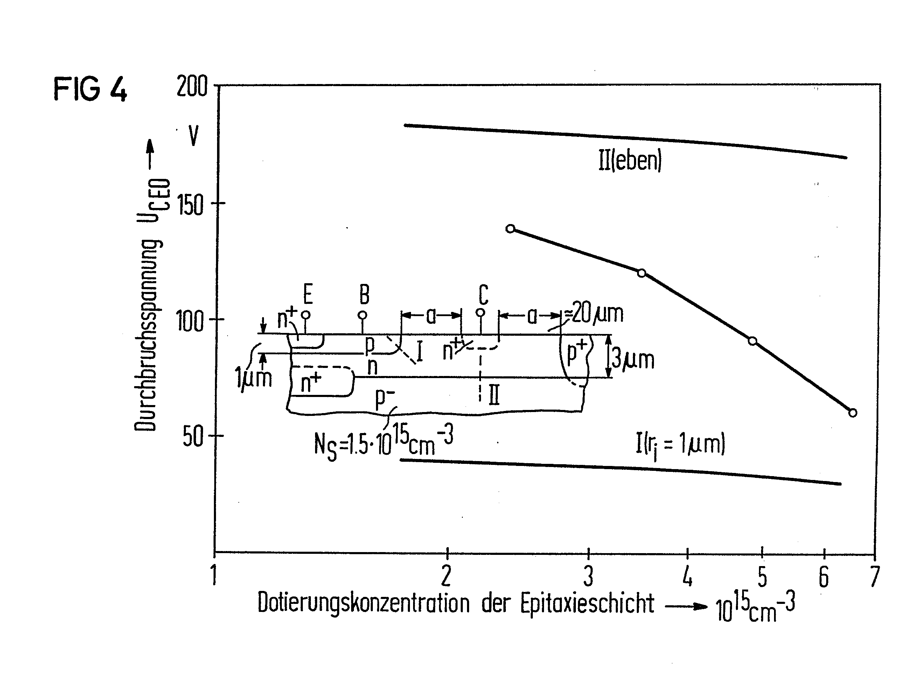

Beispiele für die Verhältnisse bei einem der Erfindung entsprechenden npn-Transistor lassen sich aus Figur 4 entnehmen. Für einen konkreten Anwendungsfall kann die für eine bestimmte Durchbruchspannung $U_{CEO}$ notwendige Epitaxiedotierung der Figur 4 entnommen werden. Für pnp-Transistoren gelten im Prinzip dieselben Betrachtungen, jedoch mit etwas abgeänderten Werten.

Für die in der Bipolartechnik üblichen Oxyddicken (0,2 - 1 μm) und Epitaxiedotierungen ($1 \cdot 10^{15}$ - $1 \cdot 10^{17}$ cm$^{-3}$) liegen die Einsatzspannungen des MOS-Systems im Bereich von 10 - 50 V. Dies bedeutet, daß bei größeren Spannungen entsprechende Maßnahmen ergriffen werden müssen, um eine Inversion im Kollektorgebiet zu vermeiden. Es ist deshalb gemäß der weiteren Erfindung zweckmäßig, wenn die an die Oberfläche der epitaktischen Schicht ES gelangenden Teile des Kollektors C des Transistors mit einer Isolierschicht abgedeckt sind, die in ihrem an die Oberfläche der epitaktischen Schicht angrenzenden Teil aus $SiO_2$ und in ihrem äußeren Teil ebenfalls aus $SiO_2$ besteht, während die zwischen den beiden Teilen vorgesehene mittlere Schicht aus undotiertem polykristallinem Silicium besteht. Dabei empfiehlt es sich, die einen spezifischen Widerstand von etwa $10^{10}$ Ohm·cm aufweisende Polysiliciumschicht einerseits mit dem Kollektoranschluß CA und andererseits mit dem Emitteranschluß EA unmittelbar zu verbinden, so daß das Kollektorgebiet vollständig von dem Einfluß von Leitbahnen, die über das Kollektorgebiet auf der dieses abdeckenden Isolierschicht geführt sind und sich deshalb in einer Reduktion der Durchbruchsfestigkeit auswirken könnten, abgeschirmt ist.

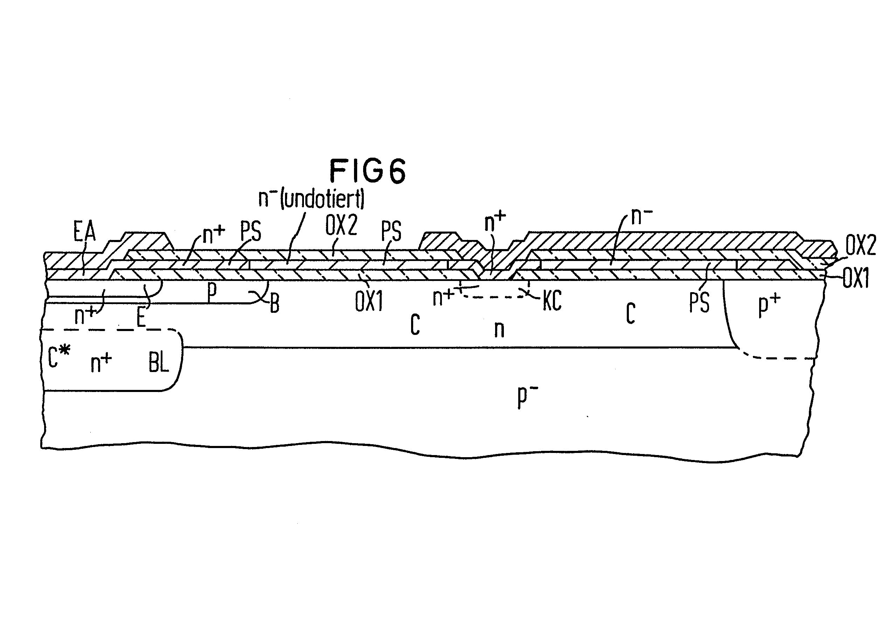

Die zuletzt aufgeführten Einzelheiten sind in der - im Wesentlichen der Figur 2 entsprechenden Figur 6 dargestellt. Die innere Oxydschicht OX1 ist durch thermische Oxydation der Oberfläche der epitaktischen Schicht ES, insbesondere noch vor der Erzeugung der Basiszone B hergestellt. Die sie abdeckende Polysiliciumschicht PS ist in an sich üblicher Weise abgeschieden und an ihrer Außenseite durch thermische Oxydation teilweise in die zweite Oxydschicht OX2 umgewandelt worden. Die übrigen in Figur 6 vorhandenen Bezugszeichen sind bereits anhand von Figur 1 bis 5 erklärt worden.

6 Figuren
5 Patentansprüche

Patentansprüche

1.) Integrierbarer bipolarer Transistor, bei dem an der Oberfläche eines monokristallinen Halbleitersubstrats vom einen Leitungstyp eine den entgegengesetzten Leitungstyp aufweisende monokristalline Halbleiterschicht epitaktisch abgeschieden und in ihr der Transistor erzeugt ist, bei der dabei am Ort des Transistors im Substrat eine vergrabene Zone hoher Dotierungskonzentration vom Leitungstyp der epitaktischen Halbleiterschicht vorgesehen und die Basiszone des Transistors oberhalb der vergrabenen Zone und mit Abstand von dieser so erzeugt ist, daß die Basiszone längs ihres Randes überall gegenüber dem Rand der vergrabenen Zone seitlich hinausragt, bei dem außerdem die Kollektorzone von dem die ursprüngliche Dotierung der epitaktischen Schicht aufweisenden Bereich gebildet ist, in dem die Basiszone eingebettet ist, und bei dem schließlich an dem die Kollektorzone begrenzenden Teil der Oberfläche der epitaktischen Schicht eine im Vergleich zur Kollektorzone stärker dotierte Kontaktierungszone mit Abstand vom Rand der Basiszone vorgesehen ist, dadurch gekennzeichnet, daß die Stärke und die Grunddotierung der epitaktischen Schicht (ES) sowie die Substratdotierung außerhalb der vergrabenen Zone (BL) derart aufeinander abgestimmt sind, daß schon bei im Vergleich zur Durchbruchspannung ($U_{CEO}$) merklich kleineren Betriebsspannungen sich die an der Grenze zwischen dem Kollektor (C) und dem Substrat (S) im Kollektorbereich (C) ausbildende Raumladungszone mit der am Kollektor-Basis-Übergang im Kollektorbereich (C) sich ausbildenden Raumladungszone in Wechselwirkung tritt, derart, daß die Kollektor-Basisspannung längs einer merklich größeren Strecke abfällt, als dies im Falle einer erheblich höheren Grunddotierung der epitaktischen Schicht (ES) der Fall wäre.

**0092671**

2.) Transistor nach Anspruch 1, dadurch gekennzeichnet, daß der Abstand (a) zwischen dem Rand der Basiszone (B) und der Kollektorkontaktierungszone (KC) so eingestellt ist, daß bei der für den Betrieb des Transistors vorgesehenen Basis-Kollektorspannung nirgends in dem Bereich zwischen dem Rand der Basiszone und der Kollektoranschlußzone (KC) die Durchbruchsfeldstärke auftreten kann.

3.) Transistor nach Anspruch 1 oder 2, dadurch gekennzeichnet, daß die Tiefe der Kollektoranschlußzone (KC) nicht größer als die Tiefe der Emitterzone (E) eingestellt und insbesondere beide Zonen in einem gemeinsamen Dotierungsprozeß hergestellt sind.

4.) Transistor nach einem der Ansprüche 1 bis 3, dadurch gekennzeichnet, daß die epitaktische Schicht (ES) wenigstens am Ort des Kollektors (C) überall mit einer aus drei übereinander angeordneten Schichten bestehenden Isolation versehen ist, derart , daß die innere und die äußere Isolierschicht aus $SiO_2$ und die mittlere aus undotiertem polykristallinen Silicium besteht.

5.) Transistor nach Anspruch 4, dadurch gekennzeichnet, daß die aus polykristallinem Silicium bestehende mittlere Isolierschicht (PS) sowohl mit dem Kollektoranschluß (CA) als auch mit dem Emitteranschluß (EA) unmittelbar verbunden ist.

FIG 1a

FIG 1b

FIG 2

FIG 3a

FIG 3b

FIG 4

3/5

0092671

## FIG 5a

$N_{EPI} = 5 \times 10^{15} cm^{-3}$

Kollektorstrom (ortikal): 200 μA/Skalenteil
Kollektor-Ermitter-Spannung(horizontal): 10 V/Skalenteil
Basisstrom: 5μA per Step

## FIG 5b

$N_{EPI} = 2 \times 10^{15} cm^{-3}$

Kollektorstrom (vertikal): 100μA/Skalenteil
Kollektor-Ermitter-Spannung (horizontal): 20V/Skalenteil
Basisstrom: 2μA per Step

0092671

## FIG6